# EUROPÄISCHE PATENTSCHRIFT

(11) **EP 3 045 024 B1**
(45) Veröffentlichungstag und Bekanntmachung des Hinweises auf die Patenterteilung: **01.03.2017**
(21) Anmeldenummer: 14739074.4
(22) Anmeldetag: 26.06.2014
(51) Int. Cl.: H05K 3/34, B23K 1/012

(54) **VORRICHTUNG ZUR ZUFÜHRUNG EINES HEISSGASSTROMS**
DEVICE FOR FEEDING A STREAM OF HOT GAS
DISPOSITIF PERMETTANT D'AMENER UN COURANT DE GAZ CHAUD

(30) Priorität: 09.09.2013 DE 102013217952
(43) Veröffentlichungstag der Anmeldung: 20.07.2016
(73) Patentinhaber: Ersa GmbH, 97877 Wertheim (DE)
(72) Erfinder: ENDRESS, Lothar, 97877 Wertheim (DE); BECK, Hermann, 97076 Würzburg (DE)
(74) Vertreter: advotec.
(86) Internationale Anmeldenummer: PCT/EP2014/063560
(87) Internationale Veröffentlichungsnummer: WO 2015/032517

(56) Entgegenhaltungen:
- EP-A1- 1 870 191
- WO-A1-99/21676
- DE-A1- 3 915 778
- US-A- 4 466 788
- US-A1- 2002 116 090
- US-A1- 2012 100 668
- US-B1- 6 347 734

## Beschreibung

Die Erfindung betrifft eine Vorrichtung zur Zuführung eines Heißgasstroms an eine Leiterplatte gemäß dem Oberbegriff von Patentanspruch 1.

Es ist bekannt, bei der Herstellung bestückter Leiterplatten die auf der Leiterplatte angeordneten Bauteile durch Heißluftlöten mit der Leiterplatte zu verbinden.

Bei Reflow- bzw. Konvektionslötanlagen werden dafür beispielsweise mit Heißgasdüsen ausgestattete Heißgas-Lötvorrichtungen verwendet. Dabei wird Heißluft bzw. Heißgas durch die Heißgasdüsen an die Lötstellen im Bereich der Kontaktpins der Bauteile geblasen, und so das Lot zum Schmelzen gebracht.

Die Heißgasdüsen können hierzu beispielsweise auf Düsenblechen bzw. Düsenplatten angeordnet sein, wobei die Düsenbleche bzw. Düsenplatten typischerweise unterhalb, jedoch auch oberhalb der durch die Lötanlage transportierten Platinen angeordnet werden können. Hierbei ist es für eine gute Wärmeübertragung bei gleichzeitig möglichst geringem Energieeinsatz erforderlich, dass die Leiterplatten möglichst nahe an den Düsenplatten mit den darauf angeordneten Heißgasdüsen positioniert werden, um auf diese Weise eine möglichst direkte Beaufschlagung der Lötstellen mit Heißgas zu erzielen.

Es können jedoch bei Leiterplatten, deren Verhältnis von Breite zu Dicke relativ groß ist, ebenso wie bei flexiblen oder folienbasierten Leiterplatten, bei zunehmender Erwärmung in einer Lötmaschine Durchbiegungen in der Mitte der Leiterplatten auftreten. Um derartigen unerwünschten Durchbiegungen entgegenzuwirken, besitzen Reflow- bzw. Konvektionslötanlagen üblicherweise Einrichtungen zur Mittenunterstützung der Leiterplatten beim Transport durch den Heißgasbereich. Derartige Einrichtungen zur Mittenunterstützung unterstützen die Leiterplatten üblicherweise an einer Position zwischen den gegenüberliegenden Seitenkanten der Platinen. Bekannte Systeme zur Mittenunterstützung machen beispielsweise von einem umlaufenden Seil oder von einer umlaufenden Kette Gebrauch, welche die Leiterplatten z.B. mittig unterstützt. Auch punktuell unterstützende, mitlaufende Stützbolzen sind bekannt.

Derartige Einrichtungen zur Mittenunterstützung von Leiterplatten nehmen jedoch Bauraum im Bereich der Heißgaszuführung in Anspruch. Insbesondere bei einer Verstellung der Mittenunterstützung quer zur Transportrichtung der Platinen, oder auch beim Vorhandensein anderweitiger Störkonturen im Bereich der Platinenoberfläche bzw. der Heißgasdüsen, ist es zudem erforderlich, dass die Mittenunterstützung bzw. die Platinen einen ausreichenden Abstand zu den bekannten Düsenplatten mit den darauf angeordneten Heißgasdüsen aufweisen. Damit wird verhindert, dass die Düsen mit der Mittenunterstützung bzw. mit etwaigen weiteren Störkonturen kollidieren, wenn die Platinen durch den Heißgasbereich transportiert werden, oder wenn die Mittenunterstützung quer zur Transportrichtung der Platinen verstellt werden muss.

Der damit verbundene erhöhte Abstand zwischen den Düsenplatten bzw. den Austrittsöffnungen der Heißgasdüsen und der Platinenoberfläche führt jedoch zu Energieverlust und zu einer nicht optimalen Wärmeübertragung auf die Platinen bzw. aufzuschmelzenden Lötstellen.

EP 1870 191 A1 offenbart eine solche Vorrichtung zur Zuführung eines Heißgasstroms an eine Leiterplatte in einer Lötmaschine.

Der Erfindung liegt demzufolge die Aufgabe zugrunde, eine Vorrichtung zur Zuführung eines Heißgasstroms an eine Leiterplatte zu schaffen, mit der sich die vorgenannten Nachteile bzw. Einschränkungen überwinden lassen. Insbesondere soll auch bei Lötanlagen mit Mittenunterstützung ein möglichst geringer Abstand zwischen Düsenplatte bzw. Heißgasdüsen einerseits und Platinenoberfläche andererseits ermöglicht werden.

Diese Aufgabe wird durch eine Vorrichtung nach der Lehre des Patentanspruchs 1 gelöst. Vorteilhafte Ausgestaltungen der Erfindung sind Gegenstand der Unteransprüche.

Die Vorrichtung zur Zuführung eines Heißgasstroms gemäß der vorliegenden Erfindung weist in zunächst bekannter Weise eine Düsenplatte mit zumindest einer Bohrung auf. Dabei ist der zumindest einen Bohrung eine auf der Düsenplatte angeordnete Heißgasdüse zugeordnet dergestalt, dass die Bohrung in die Heißgasdüse mündet.

Wird die Düsenplatte somit rückseitig mit Heißgas beaufschlagt, so fließt dieses durch die zumindest eine Bohrung der Düsenplatte sowie durch die Heißgasdüse und tritt aus der Düsenöffnung der Heißgasdüse aus.

Erfindungsgemäß zeichnet sich die Heißgas-Zuführungsvorrichtung jedoch dadurch aus, dass die zumindest eine Heißgasdüse durch eine Schraubenfeder gebildet ist. Aufgrund der als Schraubenfeder ausgeführten Heißgasdüse lässt sich die Heißgasdüse flexibel ausbilden. Dies ermöglicht, dass Objekte oder Baugruppen, die mit einer starren Heißgasdüse kollidieren würden, die flexible, als Schraubenfeder ausgebildete Heißgasdüse gemäß der Erfindung ohne Beschädigung beiseite drücken können. Dies gilt insbesondere auch für die Mittenunterstützung der Transporteinrichtung, mit der die Platinen durch den Heißgasbereich transportiert werden.

Die Platinenoberfläche kann somit beispielsweise auch beim Vorhandensein einer Mittenunterstützung, oder beim Vorhandensein anderweitiger Störkonturen im Bereich der Platinenoberfläche bzw. der Heißgasdüsen, sehr nahe an der Düsenplatte mit den erfindungsgemäß ausgebildeten Heißgasdüsen positioniert werden, wodurch sich die gewünschte direkte Wärmeübertragung unter nur minimalen Energieverlusten ergibt. Wie die Anmelderin in Versuchen festgestellt hat, kann dank der erfindungsgemäß als Schraubenfedern ausgebildeten Heißgasdüsen auf diese Weise mit erheblich reduzierter, teilweise bis halbierter Energie die gleiche Wärmemenge wie bei einer Düsenplatte mit starren Heißgasdüsen und dadurch dort größerem Abstand zwischen Düsenöffnungen und den zu erwärmenden Platinen bzw. Lötstellen auf die Platinen übertragen werden.

Auch während eine Mittenunterstützung für die Platinen betrieben oder zur Verstellung etwa quer zur Transportrichtung der Platinen verfahren wird, muss dank der Erfindung kein erhöhter Abstand mehr von der Düsenplatte mit den Heißgasdüsen eingehalten werden. Vielmehr kann die Mittenunterstützung trotz etwaiger Kollision mit den Heißgasdüsen betrieben oder verfahren werden, da diese erfindungsgemäß als nachgiebige Schraubenfedern ausgebildet sind.

Die als Schraubenfeder ausgebildete Heißgasdüse kann das Heißgas besonders effizient zum Düsenaustritt transportieren, wenn die Schraubenfeder, wie dies gemäß einer besonders bevorzugten Ausführungsform der Erfindung vorgesehen ist, eine auf Block gewickelte Schraubenzugfeder ist. Dies bedeutet, dass die Windungen der Schraubenfeder im kräftefreien Zustand der Schraubenfeder unmittelbar aufeinander aufliegen, wodurch seitlicher Heißgasaustritt zwischen den Windungen der Schraubenfeder unterbunden ist.

Die Erfindung wird ferner unabhängig davon verwirklicht, wie Schraubenfeder und Düsenplatte miteinander verbunden sind. Gemäß einer besonders bevorzugten Ausführungsform jedoch durchdringt die Schraubenfeder die ihr zugeordnete Bohrung der Düsenplatte, und ist vorzugsweise in die Bohrung der Düsenplatte eingepresst. Auf diese Weise lassen sich die als Schraubenfedern ausgebildeten Heißgasdüsen schnell und einfach auf der Düsenplatte montieren.

Gemäß einer hierzu alternativen Ausführungsform weist die Bohrung der Düsenplatte ein bezüglich Durchmesser und Steigung mit der Schraubenfeder übereinstimmendes Gewinde auf. Diese Ausführungsform ermöglicht, dass die Schraubenfeder einfach in die Düsenplatte eingeschraubt werden kann, ohne dass zusätzliche Elemente zur Befestigung oder Fixierung erforderlich sind.

Eine weitere Ausführungsform der Erfindung sieht vor, dass die Bohrung der Düsenplatte im Bereich des schraubenfederseitigen Auslaufs konisch oder gerundet aufgeweitet ist. Auf diese Weise werden Spannungsspitzen bei der Auslenkung der Schraubenfedern im Fall der Kollision beispielsweise mit der Mittenunterstützung der Lötanlage vermieden, und die Lebensdauer der Schraubenfedern wird somit erhöht.

Nach einer weiteren möglichen Ausführungsform der Erfindung schließlich ist vorgesehen, dass die Schraubenfeder im Bereich des Heißgasaustritts konisch oder düsenförmig zulaufend ausgeformt ist. Auf diese Weise erfolgt die Wärmeübertragung durch den Heißgasstrom auf die Platine in noch effektiverer Weise.

Im Folgenden wird die Erfindung anhand lediglich Ausführungsbeispiele darstellender Zeichnungen erläutert.

Dabei zeigt:
- **Fig. 1**: in schematischer isometrischer Darstellung eine Düsenplatte mit Heißgasdüsen gemäß einem Ausführungsbeispiel der vorliegenden Erfindung; und
- **Fig. 2**: in einer vergrößerten Ausschnittsdarstellung einen Bereich der Düsenplatte gemäß **Fig. 1** in mit einer Anzahl von Heißgasdüsen.

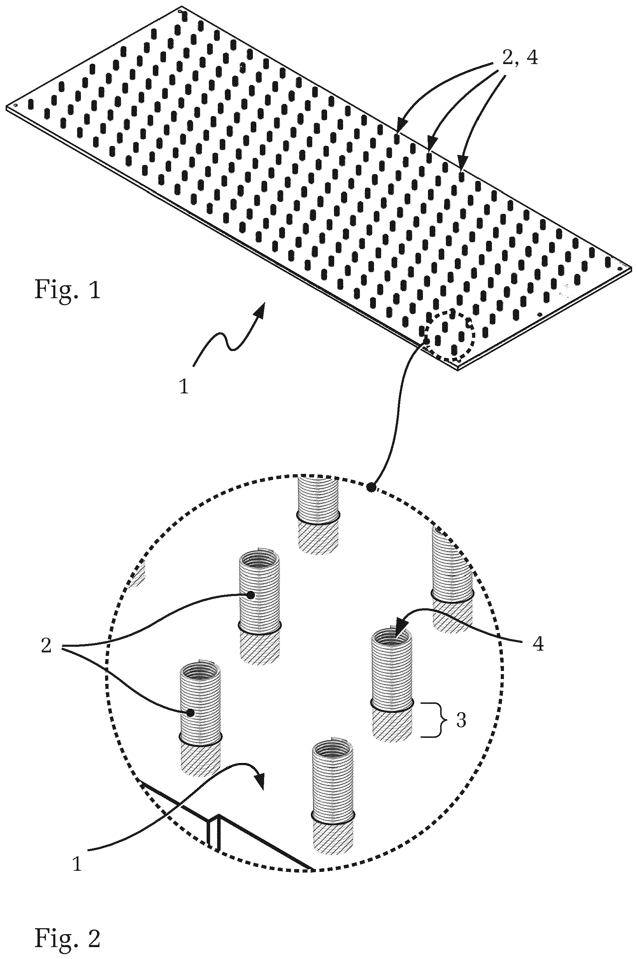

Man erkennt in **Fig. 1** eine schematisch dargestellte Düsenplatte 1 mit einer Vielzahl an Heißgasdüsen 2. Die Düsenplatte 1 lässt sich in einer Lötmaschine beispielsweise unterhalb der durch die Lötmaschine zu transportierenden Leiterplatten so anordnen, dass der aus den Düsenöffnungen 4 (zeichnungsbezogen nach oben) austretende Heißgasstrom die Lötstellen an den Platinen erwärmt und zum gewünschten Aufschmelzen des Lotes führt.

**Fig. 2** zeigt die erfindungsgemäß als Schraubenfedern ausgebildeten Heißgasdüsen 2 in einer vergrößerten Ausschnittsdarstellung. Man erkennt, dass die Heißgasdüsen 2 in einem Überlappungsbereich zu etwa einem Drittel in entsprechenden Bohrungen 3 der Düsenplatte 1 eingelassen, beispielsweise in entsprechende Gewinde eingeschraubt sind.

Dies bedeutet, dass die Montage der Düsenplatte mit den erfindungsgemäßen, elastischen Heißgasdüsen nur entsprechend geringen Aufwand und Kosten verursacht. Gleichzeitig ist die auf diese Weise erhaltene, erfindungsgemäße Heißgas-Zuführungsvorrichtung im Betrieb besonders robust, da Kollisionen der Heißgasdüsen 2 mit anderen Baugruppen der Lötanlage keine Schäden mehr verursachen können. Insgesamt ergibt sich somit die Lösung der erfindungsgemäßen Aufgabe, insbesondere einer verbesserten Wärmeübertragung oder einer bei gleicher Wärmeübertragung deutlich geringeren Energieaufnahme, durch die mit der Erfindung möglich gewordenen, verringerten Abstände zwischen den Düsenöffnungen 4 und den zu erwärmenden Platinen bzw. Lötstellen.

### Bezugszeichenliste

- 1: Düsenplatte
- 2: Heißgasdüse, Schraubenfeder
- 3: Bohrung, Überlappungsbereich
- 4: Düsenöffnung

## Patentansprüche

1. Vorrichtung zur Zuführung eines Heißgasstroms an eine Leiterplatte in einer Lötmaschine, die Vorrichtung umfassend eine Düsenplatte (1) mit zumindest einer Bohrung (3), wobei die Bohrung (3) in eine auf der Düsenplatte (1) angeordnete Heißgasdüse (2) mündet,
**dadurch gekennzeichnet,**
**dass** die Heißgasdüse durch eine Schraubenfeder (2) gebildet ist.

2. Zuführungsvorrichtung nach Anspruch 1,
**dadurch gekennzeichnet,**
**dass** die Schraubenfeder (2) eine auf Block gewickelte Schraubenzugfeder ist.

3. Zuführungsvorrichtung nach Anspruch 1 oder 2,
**dadurch gekennzeichnet,**
**dass** die Schraubenfeder (2) die Bohrung (3) der Düsenplatte (1) durchdringt.

4. Zuführungsvorrichtung nach einem der Ansprüche 1 bis 3,
**dadurch gekennzeichnet,**
**dass** die Schraubenfeder (2) in die Bohrung (3) der Düsenplatte (1) eingepresst ist.

5. Zuführungsvorrichtung nach einem der Ansprüche 1 bis 3,
**dadurch gekennzeichnet,**
**dass** die Bohrung (3) der Düsenplatte (1) ein bezüglich Durchmesser und Steigung mit der Schraubenfeder (2) übereinstimmendes Gewinde zur Aufnahme der Schraubenfeder (2) aufweist.

6. Zuführungsvorrichtung nach einem der Ansprüche 1 bis 5,
**dadurch gekennzeichnet,**
**dass** die Bohrung (3) der Düsenplatte (1) im Bereich des schraubenfederseitigen Auslaufs konisch oder gerundet aufgeweitet ist.

7. Zuführungsvorrichtung nach einem der Ansprüche 1 bis 6,
**dadurch gekennzeichnet,**
**dass** die Schraubenfeder (2) im Bereich des Heißgasaustritts (4) konisch bzw. düsenförmig zulaufend ausgebildet ist.

## Claims

1. A device for feeding a stream of hot gas to a printed circuit board in a soldering machine, the device comprising a nozzle plate (1) having at least one drilled hole (3), wherein the drilled hole (3) opens into a hot gas nozzle (2) arranged on the nozzle plate (1),
**characterized in that**
the hot gas nozzle is formed by a helical spring (2).

2. The feed device according to claim 1,
**characterized in that**
the helical spring (2) is a tension spring wound to block thickness.

3. The feed device according to claim 1 or 2,
**characterized in that**
the helical spring (2) penetrates the drilled hole (3) of the nozzle plate (1).

4. The feed device according to one of claims 1 to 3,
**characterized in that**
the helical spring (2) has been pressed into the drilled hole (3) of the nozzle plate (1).

5. The feed device according to one of claims 1 to 3,
**characterized in that**
the drilled hole (3) of the nozzle plate (1) features a thread concurrent with the helical spring (2) in terms of its diameter and its lead, for receiving the helical spring (2).

6. The feed device according to one of claims 1 to 5,
**characterized in that**
the drilled hole (3) of the nozzle plate (1), in the area of the runout on the side of the helical spring, is widened in a conical or rounded fashion.

7. The feed device according to one of claims 1 to 6,
**characterized in that**
the helical spring (2), in the area of the hot gas outlet (4), is embodied so as to be tapered in a conical fashion or in the shape of a nozzle.

## Revendications

1. Dispositif pour alimenter un courant de gaz chaud vers un circuit imprimé dans une machine de brasage, ledit dispositif comprenant une plaque à buses (1) ayant au moins un perçage (3), ledit perçage (3) s'ouvrant dans une buse à gaz chaud (2) disposée sur une plaque à buses (1),
**caractérisé en ce que**
la buse à gaz chaud est formée par un ressort hélicoïdal (2).

2. Dispositif d'alimentation selon la revendication 1,
**caractérisé en ce que**
le ressort hélicoïdal (2) est un ressort hélicoïdal de tension enroulé pour bloquer une épaisseur.

3. Dispositif d'alimentation selon la revendication 1 ou 2,
**caractérisé en ce que**
le ressort hélicoïdal (2) perce le perçage (3) de la plaque à buses (1).

4. Dispositif d'alimentation selon l'une quelconque des revendications 1 à 3,
**caractérisé en ce que**
le ressort hélicoïdal (2) est enfoncé dans le perçage (3) de la plaque à buses (1).

5. Dispositif d'alimentation selon l'une quelconque des revendications 1 à 3,
**caractérisé en ce que**
le perçage (3) de la plaque à buses (1) comprend un filetage correspondant au ressort hélicoïdal (2) concernant le diamètre et la pente pour recevoir le ressort hélicoïdal (2).

6. Dispositif d'alimentation selon l'une quelconque des revendications 1 à 5,
**caractérisé en ce que**
le perçage (3) de la plaque à buses (1) est élargi de manière conique ou arrondie dans la région de la sortie du côté du ressort hélicoïdal.

7. Dispositif d'alimentation selon l'une quelconque des revendications 1 à 6,
**caractérisé en ce que**
le ressort hélicoïdal (2) est réalisé de sorte que le ressort hélicoïdal (2) soit effilé de manière conique ou en forme de buse dans la région de la sortie de gaz chaud (4).
